(19) Europäisches Patentamt
European Patent Office
Office européen des brevets

(11) **EP 4 236 006 A1**

(12) **EUROPEAN PATENT APPLICATION**
published in accordance with Art. 153(4) EPC

(43) Date of publication:
**30.08.2023 Bulletin 2023/35**

(21) Application number: **21956350.9**

(22) Date of filing: **08.09.2021**

(51) International Patent Classification (IPC):
**H02J 7/00** (2006.01)

(52) Cooperative Patent Classification (CPC):
**H02J 7/00; Y02E 60/10**

(86) International application number:
**PCT/CN2021/117312**

(87) International publication number:
**WO 2023/035162 (16.03.2023 Gazette 2023/11)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(71) Applicant: **Contemporary Amperex Technology
Co., Limited
Ningde, Fujian 352100 (CN)**

(72) Inventors:
• **HUANG, Shan
Ningde, Fujian 352100 (CN)**

• **LI, Shichao
Ningde, Fujian 352100 (CN)**
• **LI, Haili
Ningde, Fujian 352100 (CN)**
• **ZHAO, Wei
Ningde, Fujian 352100 (CN)**
• **LIN, Zhen
Ningde, Fujian 352100 (CN)**

(74) Representative: **Frick, Robert
Lorenz Seidler Gossel
Rechtsanwälte Patentanwälte
Partnerschaft mbB
Widenmayerstraße 23
80538 München (DE)**

(54) **METHOD FOR CHARGING POWER BATTERY AND BATTERY MANAGEMENT SYSTEM**

(57) Embodiments of the present application provide a method for charging a traction battery and a battery management system, where the method includes: obtaining an actual charging current of a traction battery during a charging process of the traction battery; and determining, based on a degree of the actual charging current exceeding a requested charging current, whether to control the traction battery to be discharged. The method and the battery management system in the embodiments of the present application can improve the safety performance of the traction battery.

FIG. 2

## Description

Technical Field

The present application relates to the field of battery technologies, and in particular, to a method for charging a traction battery and a battery management system.

Background Art

With the development of the times, electric vehicles have huge market prospects due to their high environmental protection, low noise, and low usage cost, and can effectively promote energy conservation and emission reduction, which is conducive to the development and progress of society.

Battery technologies are an important factor for the development of electric vehicles and the related art, especially the safety performance of batteries, which affects the development and application of battery-related products, and affects the public acceptance of electric vehicles. Therefore, how to improve the safety performance of traction batteries is a technical problem to be solved.

Summary of the Invention

Embodiments of the present application provide a method for charging a traction battery and a battery management system, which can improve the safety performance of the traction battery.

According to a first aspect, there is provided a method for charging a traction battery, including: obtaining an actual charging current of a traction battery during a charging process of the traction battery; and determining, based on a degree of the actual charging current exceeding a requested charging current, whether to control the traction battery to be discharged.

Determining, based on the degree of the actual charging current exceeding the requested charging current, whether to control the traction battery to be discharged is conducive to suppressing lithium precipitation without affecting the charging efficiency of the battery, and achieves the purpose of safe and fast charging, so that the safety performance of the traction battery can be improved.

In conjunction with the first aspect, in a first possible implementation of the first aspect, the determining, based on a degree of the actual charging current exceeding a requested charging current, whether to control the traction battery to be discharged includes: when a ratio of a difference between the actual charging current and the requested charging current to the requested charging current is greater than a first threshold, determining to control the traction battery to be discharged.

When the actual charging current is greater than the requested charging current, the traction battery may have a risk of lithium precipitation. However, since there is usually a specific margin for the magnitude of the requested charging current within the safety performance of the traction battery, the traction battery can be controlled to be discharged when the actual charging current exceeds the requested charging current by a specific degree, which may minimize an impact on the charging efficiency while reducing the risk of lithium precipitation of the traction battery.

In conjunction with some implementations of the first aspect, in a second possible implementation of the first aspect, the determining, based on a degree of the actual charging current exceeding a requested charging current, whether to control the traction battery to be discharged includes: when a ratio of a difference between the actual charging current and the requested charging current to the requested charging current is greater than a first threshold, determining an ampere-hour integral of the difference between the actual charging current and the requested charging current; and when the ampere-hour integral is greater than a second threshold, determining to control the traction battery to be discharged.

Generally, the greater the degree by which the actual charging current exceeds the requested charging current, the more timely the discharging needs to be performed. When the actual charging current of the traction battery exceeds the requested charging current by a specific degree, whether an overcharging capacity of the traction battery is greater than a specific threshold is determined, which is conducive to reducing the risk of lithium precipitation of the traction battery accurately and in a timely manner.

In conjunction with some implementations of the first aspect, in a third possible implementation of the first aspect, the method further includes: when it is determined to control the traction battery to be discharged, sending first charging request information to a charging pile, the first charging request information being used to request that a charging current be 0; and when the collected actual charging current of the traction battery is less than or equal to a third threshold, controlling the traction battery to be discharged.

When the collected actual charging current of the traction battery is less than or equal to the third threshold, the traction battery is controlled to be discharged, which is conducive to improving a suppressing effect of the discharging of the traction battery on lithium precipitation of the battery.

In conjunction with some implementations of the first aspect, in a fourth possible implementation of the first aspect, the method further includes: when a duration elapsed after the first charging request information is sent is greater than or equal to a first preset time interval, controlling the traction battery to stop being discharged.

In conjunction with some implementations of the first aspect, in a fifth possible implementation of the first aspect, the method further includes: when a duration for controlling the traction battery to be discharged is greater than or equal to a second preset time interval, controlling the traction battery to stop being discharged.

Controlling the traction battery to be discharged within a specific period of time may minimize the impact on the charging efficiency under the premise of suppressing lithium precipitation, and at the same time may avoid abnormal gun unplugging due to long-time discharging.

In conjunction with some implementations of the first aspect, in a sixth possible implementation of the first aspect, the method further includes: when the traction battery is controlled to stop being discharged, sending second charging request information to the charging pile based on a charging matching table, the second charging request information being used to request the charging pile to charge the traction battery.

According to a second aspect, there is provided a battery management system, including: an obtaining module configured to obtain an actual charging current of a traction battery during a charging process of the traction battery; and a determining module configured to determine, based on a degree of the actual charging current exceeding a requested charging current, whether to control the traction battery to be discharged.

In conjunction with the second aspect, in a first possible implementation of the second aspect, the determining module is specifically configured to: when a ratio of a difference between the actual charging current and the requested charging current to the requested charging current is greater than a first threshold, determine to control the traction battery to be discharged.

In conjunction with the second aspect, in a second possible implementation of the second aspect, the determining module is specifically configured to: when a ratio of a difference between the actual charging current and the requested charging current to the requested charging current is greater than a first threshold, determine an ampere-hour integral of the difference between the actual charging current and the requested charging current; and when the ampere-hour integral is greater than a second threshold, determine to control the traction battery to be discharged.

In conjunction with the second aspect, in a third possible implementation of the second aspect, the battery management system further includes: a communication module configured to: when it is determined to control the traction battery to be discharged, send first charging request information to a charging pile, the first charging request information being used to request that a charging current be 0; and a control module configured to: when the collected actual charging current of the traction battery is less than or equal to a third threshold, control the traction battery to be discharged.

In conjunction with the second aspect, in a fourth possible implementation of the second aspect, the control module is further configured to: when a duration elapsed after the first charging request information is sent is greater than or equal to a first preset time interval, control the traction battery to stop being discharged.

In conjunction with the second aspect, in a fifth possible implementation of the second aspect, the battery management system further includes: a control module configured to: when a duration for controlling the traction battery to be discharged is greater than or equal to a second preset time interval, control the traction battery to stop being discharged.

In conjunction with the second aspect, in a sixth possible implementation of the second aspect, the battery management system further includes: a communication module configured to: when the traction battery is controlled to stop being discharged, send second charging request information to the charging pile based on a charging matching table, the second charging request information being used to request the charging pile to charge the traction battery.

According to a third aspect, there is provided a battery management system, including a memory and a processor, where the memory is configured to store instructions, and the processor is configured to read the instructions and perform, based on the instructions, the method in the first aspect or any of the possible implementations in the first aspect.

According to a fourth aspect, there is provided a readable storage medium configured to store a computer program, where the computer program is used to perform the method in the first aspect or any of the possible implementations in the first aspect.

Brief Description of the Drawings

In order to illustrate the technical solutions of the embodiments of the present application more clearly, the drawings required in the description of the embodiments of the present application will be described briefly below. Obviously, the drawings described below are merely some embodiments of the present application, and for those of ordinary skill in the art, other drawings can also be obtained from these drawings without any creative efforts.

FIG. 1 is a schematic block diagram of a battery system to which an embodiment of the present application is applicable;
FIG. 2 is a schematic block diagram of a method for charging a traction battery according to an embodiment of the present application;
FIG. 3 is a schematic block diagram of a method for charging a traction battery according to another embodiment of the present application;
FIG. 4 is a schematic block diagram of a method for charging a traction battery according to still another embodiment of the present application;
FIG. 5 is a schematic diagram of a current as a function of time according to an embodiment of the present application;
FIG. 6 is a schematic flowchart of a method for charging a traction battery according to an embodiment of the present application;

FIG. 7 is a schematic flowchart of a method for charging a traction battery according to another embodiment of the present application;

FIG. 8 is a schematic block diagram of a battery management system according to an embodiment of the present application; and

FIG. 9 is a schematic block diagram of a battery management system according to another embodiment of the present application.

Detailed Description of Embodiments

The implementations of the present application will be further described in detail below in conjunction with the accompanying drawings and embodiments. The following detailed description of the embodiments and the accompanying drawings are used to illustrate the principle of the present application by way of example but should not be used to limit the scope of the present application. That is, the present application is not limited to the described embodiments.

In the description of the present application, it should be noted that "multiple" means two or more, unless otherwise specified. The orientation or position relationship indicated by the terms "upper", "lower", "left", "right", "inner", "outer", etc. is only for the convenience of describing the present application and simplifying the description, rather than indicating or implying that the apparatus or element referred to must have a particular orientation or be constructed and operated in a particular orientation, and therefore should not be construed as a limitation on the present application. In addition, the terms "first", "second", "third", etc. are used for descriptive purposes only, and should not be construed as indicating or implying the relative importance. The term "perpendicular" does not mean being perpendicular in the strict sense, but within an allowable range of errors. The term "parallel" does not mean being parallel in the strict sense, but within an allowable range of errors.

The orientation terms in the following description all indicate directions shown in the drawings, but do not limit the specific structure in the present application. In the description of the present application, it should also be noted that the terms "disposing", "connecting", and "connection" should be interpreted in the broad sense unless explicitly defined and limited otherwise. For example, the terms may mean a fixed connection, a detachable connection, or an integral connection, or may mean a direct connection, or an indirect connection by means of an intermediate medium. For those of ordinary skill in the art, the specific meanings of the terms mentioned above in the present application can be construed according to specific circumstances.

In the new energy field, a traction battery is used as a main power source for a power consuming apparatus, such as a vehicle, a ship, or a spacecraft. The importance of traction batteries is self-evident. At present, most of the traction batteries on the market are rechargeable batteries, and the common ones are lithium-ion batteries or lithium ion polymer batteries.

Generally, during the charging process of a lithium-ion battery, lithium ions may be deintercalated from the positive electrode and intercalated into the negative electrode, but when some abnormal conditions occur (for example, the battery is being charged at a low temperature, or the battery is being charged at a large charging rate or charging voltage), and consequently the lithium ions deintercalated from the positive electrode cannot be intercalated into the negative electrode, the lithium ions can only be precipitated on the surface of the negative electrode, thus forming a layer of gray substance. This phenomenon is called lithium precipitation.

Lithium precipitation may not only reduce the performance and the cycle life of the battery, but also limit the fast charging capacity of the battery, and may cause disastrous consequences such as combustion and explosion.

In view of this, an embodiment of the present application provides a method for charging a traction battery, which is conducive to resolve the problem of lithium precipitation of traction batteries, so as to improve the performance of the traction batteries.

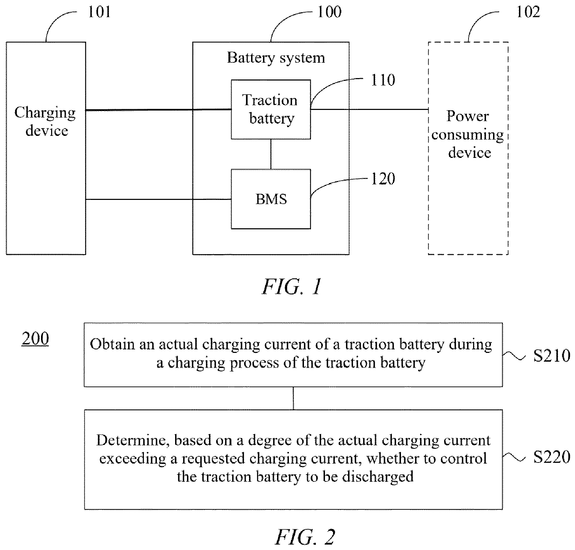

FIG. 1 shows a battery system 100 to which an embodiment of the present application is applicable. The battery system 100 may include: a traction battery 110 and a battery management system (BMS) 120.

Specifically, the traction battery 110 may include at least one battery module, which can provide energy and power for an electric vehicle. In terms of a battery type, the traction battery 110 may be a lithium-ion battery, a lithium metal battery, a lead-acid battery, a nickel-cadmium battery, a nickel-hydrogen battery, a lithium-sulfur battery, a lithium-air battery, a sodium-ion battery, or the like, which is not specifically limited in the embodiments of the present application. In terms of a battery size, in the embodiments of the present application, the battery module in the traction battery 110 may be a cell/battery cell, or may be a battery bank or a battery pack, which is not specifically limited in the embodiments of the present application.

In addition, to intelligently manage and maintain the traction battery 110, prevent the battery from failures, and prolong the service life of the battery, the battery system 100 is generally provided with a BMS 120. The BMS 120 is connected to the traction battery 110 and configured to monitor and collect a parameter of the traction battery 110, and the BMS 120 may further implement control and management of the traction battery 110 based on the parameter.

As an example, the BMS 120 may be configured to monitor parameters such as voltage, current, and temperature of the traction battery 110. The BMS 120 may collect, in real time, a total voltage and a total current of the traction battery 110, a voltage and a current of a single battery cell in the traction battery 110, a temperature at at least one temperature measurement point in the traction battery 110, etc. The real-time, fast, and accurate measurement of the parameters is the basis for the normal operating of the BMS 120.

Optionally, the BMS 120 may further estimate the state of charge (SOC), state of health (SOH), state of power (SOP), and other parameters of the traction battery 110 based on the collected parameters of the traction battery 110.

Further, after obtaining a plurality of parameters of the traction battery 110, the BMS 120 may implement, based on the plurality of parameters, control and management of the traction battery 110 in various manners.

For example, the BMS 120 may control the charging and discharging of the traction battery 110 based on parameters such as SOC, voltage, and current, so as to ensure normal energy supply and release of the traction battery 110.

For another example, the BMS 120 may further control components such as a cooling fan or a heating module based on parameters such as temperature, so as to implement thermal management of the traction battery 110.

For still another example, the BMS 120 may further determine, based on parameters such as voltage and SOH, whether the traction battery 110 is in a normal operating state, so as to implement fault diagnosis and early warning for the traction battery 110.

Optionally, as shown in FIG. 1, the battery system 100 may establish a connection with a charging device 101 and a power consuming device 102, so as to implement charging and discharging of the traction battery 100.

Optionally, the charging device 101 may include, but is not limited to, a charging pile, which may also be called a charger.

Optionally, the power consuming device 102 may include, but is not limited to, an electric vehicle or an external device.

FIG. 2 is a schematic block diagram of a method 200 for charging a traction battery according to an embodiment of the present application. Optionally, the traction battery in the embodiment of the present application may be the traction battery 110 shown in FIG. 1, and the method 200 may be applied to the BMS 120 in the battery system 100 shown in FIG. 1, that is, the method 200 may be performed by the BMS 120 in the battery system 100 shown in FIG. 1. Specifically, as shown in FIG. 2, the method 200 includes a part or all of the following content:

S210: obtaining an actual charging current of a traction battery during a charging process of the traction battery; and

S220: determining, based on a degree of the actual charging current exceeding a requested charging current, whether to control the traction battery to be discharged.

Generally, when the BMS is physically connected to a charging pile and powered on, a low-voltage auxiliary power supply is turned on, so that they enter a handshake startup phase, and send handshake packets, and insulation monitoring is then performed. After the insulation monitoring is completed, they enter a handshake identification phase and may each send an identification packet, to determine necessary information about the traction battery and the charging pile. After the charging handshake phase, the charging pile and the BMS enter a charging parameter configuration phase. In this phase, the charging pile may send a packet about a maximum output capability of the charging pile to the BMS, so that the BMS may determine, based on the maximum output capability of the charging pile, whether the charging pile can perform charging. After the charging parameter configuration phase, the charging pile and the BMS may enter a charging phase.

During the charging process of the traction battery, the BMS may send a battery charging requirement to the charging pile, and the charging pile may adjust a charging voltage and a charging current based on the battery charging requirement, to ensure a normal charging process. As an example, the battery charging requirement may carry a requested charging current. Then, the charging pile may output a current to the traction battery based on the requested charging current sent by the BMS, and the BMS may collect a charging current of the traction battery, that is, the actual charging current in the embodiment of the present application.

In an example, during the entire charging process of the traction battery, the BMS may adjust the requested charging current in real time, and send an adjusted requested charging current to the charging pile. The BMS may further collect the actual charging current of the traction battery in real time. In other words, the BMS may collect the actual charging current of the traction battery as long as the requested charging current is changed.

In another example, during the entire charging process of the traction battery, the BMS may periodically collect the actual charging current of the traction battery regardless of whether the requested charging current is changed.

Generally, if the actual charging current of the traction battery is less than or equal to the requested charging current, lithium precipitation may not occur in the battery. However, because the quality of charging piles on the market varies widely, there are uncontrollably noise and fluctuations in an actual charging current of a traction battery, and there may be a case that the actual charging current of the traction battery is greater than a requested charging current, which is very likely to cause lithium precipitation of the battery, causing a safety risk.

However, it does not mean that lithium precipitation occurs in the battery as long as the actual charging current is greater than the requested charging current. The reason is that the requested charging current is usually determined to be within a charging capability of the battery. In other words, even if the actual charging current is greater than the requested charging current, lithium precipitation may not occur in the battery as long as the actual charging current is not beyond the charging capability of the battery, that is, lithium precipitation may not occur in the battery as long as a degree of the actual charging current exceeding the requested charging current is within a specific range.

The applicant has found that during the charging process of the traction battery, controlling the traction battery to be discharged can facilitate reintercalation of lithium metal and suppress continuous accumulation of precipitated lithium metal. However, controlling the traction battery to be discharged may affect the charging efficiency of the traction battery. Therefore, determining, based on a degree of the actual charging current exceeding the requested charging current, whether to control the traction battery to be discharged may not greatly affect the charging efficiency of the traction battery, and can suppress lithium precipitation of the battery.

In other words, if the degree of the actual charging current exceeding the requested charging current is within a specific range, the traction battery is not controlled to be discharged, that is, the traction battery is controlled to be charged continuously. However, if the degree of the actual charging current exceeding the requested charging current exceeds a specific range, the traction battery is controlled to be discharged.

It should be understood that in the embodiment of the present application, when it is determined to control the traction battery to be discharged, the traction battery may be immediately controlled to be discharged.

It should also be understood that in the embodiment of the present application, controlling the traction battery to be discharged does not mean that the traction battery is kept discharged until the amount of electricity of the traction battery is 0, but that the traction battery is controlled to be discharged at a specific current for a specific period of time. After completion of controlling the traction battery to be discharged, the traction battery continues to be controlled to be charged, and steps 210 and 220 are repeated until the charging ends.

Therefore, according to the method for charging a traction battery in the embodiment of the present application, whether to control the traction battery to be discharged is determined based on the degree of the actual charging current exceeding the requested charging current, which is conducive to suppressing lithium precipitation without affecting the charging efficiency of the battery, and achieves the purpose of safe and fast charging, so that the safety performance of the traction battery can be improved.

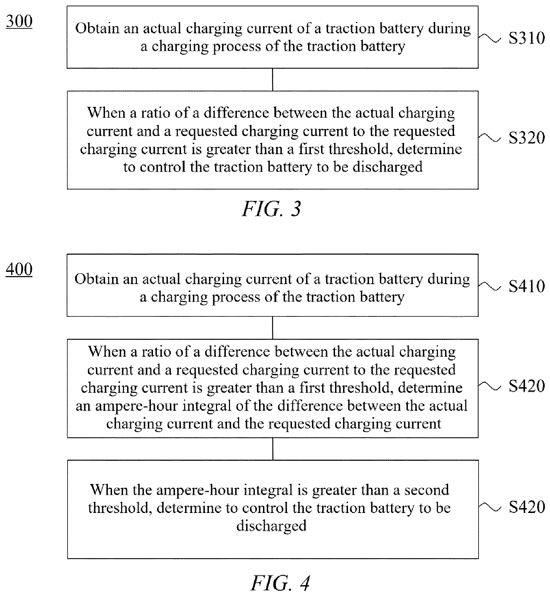

FIG. 3 is a schematic block diagram of a method 300 for charging a traction battery according to another embodiment of the present application. Optionally, the traction battery in the embodiment of the present application may be the traction battery 110 shown in FIG. 1, and the method 300 may be applied to the BMS 120 in the battery system 100 shown in FIG. 1, that is, the method 300 may be performed by the BMS 120 in the battery system 100 shown in FIG. 1. Specifically, as shown in FIG. 3, the method 300 includes a part or all of the following content:

> S310: obtaining an actual charging current of a traction battery during a charging process of the traction battery; and
>
> S320: when a ratio of a difference between the actual charging current and a requested charging current to the requested charging current is greater than a first threshold, determining to control the traction battery to be discharged.

It should be understood that, for a specific implementation of step S310, reference may be made to step S210 in the method 200. For the sake of brevity, details are not repeated herein.

In step S320, the BMS may determine, based on the following formula, to control the traction battery to be discharged:

$$(ia - io)\,/\,io > TH1_,$$

where ia represents the actual charging current of the traction battery, io represents the requested charging current, and TH1 represents the first threshold.

The first threshold may be set based on battery performance, safety requirements, etc. For example, the requested charging current is 100 A, and the charging capability of the traction battery is 110 A, and when the performance of the battery is considered, the first threshold may be set to (110 - 100) A/100 A = 0.1, that is, when a ratio of a difference between the actual charging current and the requested charging current to the requested charging current is greater than 0.1, it is considered that the traction battery has a risk of lithium precipitation, and the traction battery is controlled to be discharged. If safety requirements are considered, the first threshold may be set to be less than 0.1, for example, the first threshold is 0.08. In other words, as long as the ratio of the difference between the actual charging current and the requested charging current to the requested charging current is greater than 0.08, the traction battery is controlled to be discharged.

The first threshold may alternatively be obtained based on a critical value. The critical value may be considered as a ratio, obtained at a moment when lithium precipitation begins to occur, of a difference between the actual charging current and the requested charging current to the requested charging current. The critical value may be an empirical value, that is, the critical value may be obtained through multiple tests.

In an example, the first threshold is set to be less than the critical value, and as long as the ratio of the difference between the actual charging current and the requested charging current to the requested charging current is greater than the first threshold, the traction battery is controlled to be discharged, which may better reduce the risk of lithium precipitation.

In another example, the first threshold is set to be less than the critical value. If the ratio of the difference between the actual charging current and the requested charging current to the requested charging current is greater than the first threshold, it is determined to control the traction battery to be discharged, but the traction battery is controlled to be discharged after a specific time interval instead of being controlled to be discharged immediately. In other words, when it is determined for the first time that the ratio of the difference between the actual charging current and the requested charging current to the requested charging current is greater than the first threshold, it is determined to control the traction battery to be discharged, and a timer is started. During timing of the timer, the ratio of the difference between the actual charging current and the requested charging current to the requested charging current remains greater than the first threshold, and after the timer expires, the traction battery is controlled to be discharged. A duration of the timer may be, for example, five minutes.

When the actual charging current is greater than the requested charging current, the traction battery may have a risk of lithium precipitation. However, since there is usually a specific margin for the magnitude of the requested charging current within the safety performance of the traction battery, the traction battery can be controlled to be discharged when the actual charging current exceeds the requested charging current by a specific degree, which may minimize an impact on the charging efficiency while reducing the risk of lithium precipitation of the traction battery.

FIG. 4 is a schematic block diagram of a method 400 for charging a traction battery according to another embodiment of the present application. Optionally, the traction battery in the embodiment of the present application may be the traction battery 110 shown in FIG. 1, and the method 400 may be applied to the BMS 120 in the battery system 100 shown in FIG. 1, that is, the method 400 may be performed by the BMS 120 in the battery system 100 shown in FIG. 1. Specifically, as shown in FIG. 4, the method 400 includes a part or all of the following content:

S410: obtaining an actual charging current of a traction battery during a charging process of the traction battery;
S420: when a ratio of a difference between the actual charging current and a requested charging current to the requested charging current is greater than a first threshold, determining an ampere-hour integral of the difference between the actual charging current and the requested charging current; and
S430: when the ampere-hour integral is greater than a second threshold, determining to control the traction battery to be discharged.

It should be understood that, for a specific implementation of step S410, reference may be made to step S210 in the method 200, and for the first threshold in step S420, reference may be made to the description of the first threshold in the method 320. For the sake of brevity, details are not repeated herein.

The so-called ampere-hour integral refers to a time integral of the current. In the embodiment of the present application, the ampere-hour integral of the difference between the actual charging current and the requested charging current may be considered as an overcharging capacity obtained when the actual charging current exceeds the requested charging current by a specific degree, and an initial value of the overcharging capacity is 0. Specifically, the BMS may obtain the actual charging current and the requested charging current of the traction battery in real time. When the ratio of the difference between the actual charging current and the requested charging current to the requested charging current is greater than the first threshold, timing is started, and the starting moment is set as time t0. An overcharging capacity may be calculated at an interval of Δt, for example, an overcharging capacity between t0 and t1 is calculated at the moment t1 = t0 + Δt. In addition, the BMS may determine, each time when an overcharging capacity is calculated, whether the overcharging capacity is greater than the second threshold, and if the overcharging capacity is greater than the second threshold, it is determined to control the traction battery to be discharged. If the overcharging capacity is less than the second threshold, an overcharging capacity between t0 and t2 = t1 + Δt is calculated, and whether the obtained overcharging capacity is greater than the second threshold continues to be determined, until a calculated overcharging capacity is greater than the second threshold, and in this case, it is determined to control the traction battery to be discharged. In other words, when it is determined that the ratio of the difference between the actual charging current and the requested charging current to the requested charging current is greater than the first threshold, the BMS may determine, based on the following formula, to control the traction battery to be discharged:

$$\int_{t0}^{tn} (ia\text{-}io)dt > TH2$$

,

where ia represents the actual charging current of the traction battery, io represents the requested charging current, t0 is the moment when it is determined that the ratio of the difference between the actual charging current and the requested charging current to the requested charging current is greater than the first threshold, tn is the moment when it is determined that the overcharging capacity is greater than the second threshold, and TH2 may represent the second threshold.

Generally, the greater the degree by which the actual charging current exceeds the requested charging current, the more timely the discharging needs to be performed. When the actual charging current of the traction battery exceeds the requested charging current by a specific degree, whether an overcharging capacity of the traction battery is greater than a specific threshold is determined, which is conducive to reducing the risk of lithium precipitation of the traction battery accurately and in a timely manner.

In an example, the ratio of the difference between the actual charging current and the requested charging current to the requested charging current remains greater than the first threshold between t0 and tn. When the overcharging capacity obtained at the moment tn satisfies the above formula, it is determined to control the traction battery to be discharged, and the overcharging capacity is set to the initial value.

In another example, if the BMS determines that the overcharging capacity obtained at the moment tn is less than the second threshold, before the moment t(n+1), and the ratio of the difference between the actual charging current and the requested charging current to the requested charging current is less than or equal to the first threshold, the overcharging capacity obtained at the moment tn is stored. When it is determined again at the moment tm that the ratio of the difference between the actual charging current and the requested charging current to the requested charging current is greater than the first threshold, an overcharging capacity at the moment t(m+1) is calculated, where the overcharging capacity at the moment t(m+1) refers to an ampere-hour integral of a difference between an actual charging current and the requested charging current between tm and t(m+1), and whether the sum of the overcharging capacity obtained at the moment tn and the overcharging capacity obtained at the moment t(m+1) is greater than the second threshold is determined, and if the sum is greater than the second threshold, it is determined to control the traction battery to be discharged, and the overcharging capacity is set to the initial value, that is, the BMS may determine, based on the following formula, to control the traction battery to be discharged:

$$\int_{t0}^{tn} (ia\text{-}io)dt + \int_{tm}^{t(m+1)} (ia\text{-}io)dt > TH2 .$$

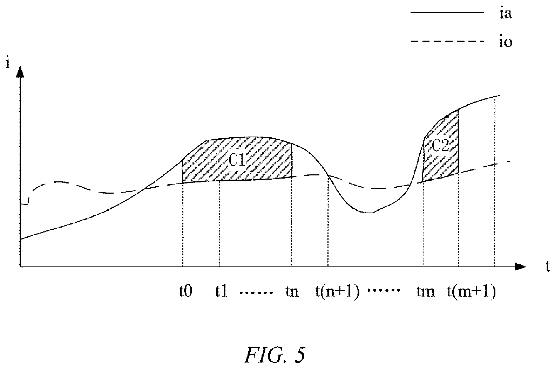

FIG. 5 is a schematic diagram of a current as a function of time according to an embodiment of the present application. As shown in FIG. 5, the requested charging current is io, and the actual charging current is ia. The BMS determines at the moment t0 that (ia-io)/io is greater than the threshold TH1, calculates at the moment t1 an overcharging capacity at the moment t1, determines whether the overcharging capacity at the moment t1 is greater than the second threshold TH2, and if it is less than TH2, continues to calculate an overcharging capacity at the moment t2, ..., and calculate an overcharging capacity at the moment tn. Each time when the BMS calculates an overcharging capacity, it may update a value of an overcharging capacity stored therein. When the overcharging capacity at the moment tn is greater than TH2, the value of the overcharging capacity stored in the BMS may be updated to the initial value of 0. When the value of the overcharging capacity at the moment tn is not greater than TH2, the value of the overcharging capacity stored in the BMS may be updated to the overcharging capacity C1 calculated at the moment tn. It should be noted that, when calculating an overcharging capacity at each moment, the BMS may calculate a value of (ia-io)/io and compare it with TH1. If (ia-io)/io at the moment t(n+1) is less than or equal to TH1, the calculation of the overcharging capacity may be stopped until (ia-io)/io at the moment tm is greater than TH1. The overcharging capacity C2 is calculated again at the moment t(m+1), the overcharging capacity in the BMS is updated to C1+C2, and if C1+C2 is greater than TH2, it is determined to control the traction battery to be discharged. If C1+C2 is not greater than TH2, an overcharging capacity at the next moment may continue to be calculated and accumulated with C1.

Similarly, the second threshold may be set based on the battery performance, safety requirements, etc. For example, the second threshold may be 0.5 AH.

Alternatively, the BMS may start timing when it is determined that the actual charging current is greater than the requested charging current, calculate an overcharging capacity at a specific moment, determine whether the overcharging capacity at this moment is greater than the second threshold, and when it is determined that the overcharging capacity at this moment is less than or equal to the second threshold and the actual charging current at the next moment is less than or equal to the requested charging current, store the last updated overcharging capacity and add it to an overcharging capacity obtained next time when the actual charging current is greater than the requested charging current, to be compared with the second threshold.

It should be understood that the second threshold in the embodiment in which timing is started when the actual charging current is greater than the requested charging current may be greater than the second threshold in the embodiment in which timing is started when the ratio of the difference between the actual charging current and the requested charging current to the requested charging current is greater than the first threshold.

Optionally, the embodiment described above in which whether the ratio of the difference between the actual charging current and the requested charging current to the requested charging current is greater than the first threshold may be replaced by an embodiment in which whether the difference between the actual charging current and the requested charging current is greater than a fourth threshold, where the fourth threshold may be equivalent to a product of the first threshold and the requested charging current. In other words, the fourth threshold is a value that changes as the requested charging current changes.

Optionally, in the embodiment of the present application, when it is determined, based on a degree of the actual charging current exceeding the requested charging current, to control the traction battery to be discharged, parameters such as the magnitude of a discharging current, a discharging duration, etc. of the traction battery may be fixed, or may be adjusted in real time.

In an example, the BMS may control, based on the same discharging parameter, the traction battery to be discharged. For example, the discharging parameter may be fixed and configured as a current of 10 A and a duration of 20s.

In another example, the BMS may control, based on a discharging parameter determined in real time, the traction battery to be discharged. For example, the discharging parameter of the traction battery may be determined based on a state parameter of the traction battery. The state parameters of the traction battery may include, for example, temperature, SOC, SOH, etc.

Optionally, the discharging parameter of the traction battery may be determined based on an SOC interval of the SOC of the traction battery. Generally, the greater the SOC of the traction battery, the higher the risk of lithium precipitation of the battery. The BMS may configure in advance discharging durations and/or discharging currents corresponding to different SOC intervals. For example, a discharging duration corresponding to a high SOC interval may be greater than a discharging duration corresponding to a low SOC interval. For another example, a discharging current corresponding to a high SOC interval may be greater than a discharging current corresponding to a low SOC interval.

Dynamically adjusting the discharging parameter of the traction battery based on the state parameter of the traction battery may better balance a relationship between lithium precipitation and a charging speed, so that fast and safe charging can be better implemented.

It should be noted that determining the discharging parameter of the traction battery and controlling the traction battery to be discharged may be considered as two independent steps that do not interfere with each other. In other words, there is no necessary time sequence relationship between determining a discharging parameter of the traction battery and controlling the traction battery to be discharged. If the discharging parameter of the traction battery is determined first, the traction battery is controlled, based on the determined discharging parameter, to be discharged; or if the discharging parameter of the traction battery is not determined first, the traction battery is controlled, based on the last determined discharging parameter, to be discharged.

Optionally, in the embodiment of the present application, the method 200 further includes: when it is determined to control the traction battery to be discharged, sending first charging request information to a charging pile, the first charging request information being used to request that a charging current be 0; and when the collected actual charging current of the traction battery is less than or equal to a third threshold, controlling the traction battery to be discharged.

The first charging request information is similar to the battery charging requirement described above, except that a requested charging current carried in the battery charging requirement is 0, that is, the first charging request information is used to request the charging pile for a charging current of 0. After receiving the first charging request information, the charging pile controls a charging current output to the traction battery to be 0. Since the actual charging current of the traction battery gradually decreases after the BMS sends the first charging request information to the charging pile, if the traction battery is controlled to be discharged immediately after the first charging request information is sent to the charging pile, a suppressing effect of discharging on lithium precipitation of the battery may be reduced.

In an example, the actual charging current of the traction battery is collected in real time, so that when the actual charging current is less than or equal to a current threshold, the traction battery is controlled to be discharged. For example, the current threshold is 50 A.

In another example, the traction battery may alternatively be controlled to be discharged after a preset duration elapsed after the first charging request information is sent to the charging pile. The preset duration may be based on an empirical value of a duration from the moment when the BMS sends the first charging request information to the charging pile to the moment when the actual charging current of the traction battery decreases to the current threshold.

Optionally, in an embodiment of the present application, the method 200 further includes: when the duration elapsed after the first charging request information is sent is greater than or equal to a first preset time interval, controlling the traction battery to stop being discharged.

For example, a timer may be started when the BMS sends the first charging request information to the charging pile, a duration of the timer may be the first preset time interval, and when the timer expires, the traction battery is controlled to stop being discharged. For example, the duration of the timer may be 60s, that is, the first preset time interval is 60s.

For another example, timing may be started when the BMS sends the first charging request information to the charging pile, and when a timing duration reaches the first preset time interval, the traction battery is controlled to stop being discharged. For example, the first preset time interval is 60s.

Optionally, in another embodiment of the present application, the method 200 further includes:

when a duration for controlling the traction battery to be discharged is greater than or equal to a second preset time interval, controlling the traction battery to stop being discharged.

For example, the timer may be started at a moment when the BMS starts to control the traction battery to be discharged, a duration of the timer may be the second preset time interval, and when the timer expires, the traction battery is controlled to stop being discharged. For example, the duration of the timer may be 20s, that is, the second preset time interval is 20s.

For another example, timing may be started when the BMS controls the traction battery to start to be discharged, and when a timing duration reaches the second preset time interval, the traction battery is controlled to stop being discharged. For example, the second preset time interval is 20s.

It should be understood that the first preset time interval and the second preset time interval may be configured.

Controlling the traction battery to be discharged within a specific period of time may minimize the impact on the charging efficiency under the premise of suppressing lithium precipitation, and at the same time may avoid abnormal gun unplugging due to long-time discharging.

Optionally, in the embodiment of the present application, the method 200 further includes: when the traction battery is controlled to stop being discharged, sending second charging request information to the charging pile based on a charging matching table, the second charging request information being used to request the charging pile to charge the traction battery.

Specifically, when controlling the traction battery to stop being discharged, the BMS may send the second charging request information to the charging pile based on the charging matching table. The second charging request information is similar to the battery charging requirement described above, and a requested charging current carried in the second charging request information is not 0, that is, the charging pile is requested to output a current to the traction battery. In other words, the BMS may store a charging matching table, the charging matching table may include correspondences between requested charging currents and various state parameters of the traction battery. When the BMS controls the traction battery to stop being discharged, the corresponding requested charging current may be obtained from the charging matching table based on a current state parameter of the traction battery, and sent to the charging pile by using the second charging request information. For example, the BMS may obtain, from the charging matching table, a requested charging current corresponding to the current SOC. After receiving the second charging request information, the charging pile outputs a non-zero charging current to the traction battery, that is, the charging pile charges the traction battery. Further, the BMS may repeat steps 210 and 220.

Optionally, in the embodiment of the present application, the method 200 further includes: when the traction battery is in a fully-charged state or a gun-unplugged state, controlling the traction battery to be discharged.

If the traction battery is in the fully-charged state or the gun-unplugged state, since it is unclear at this time whether the traction battery in the current state has a risk of lithium precipitation, a negative pulse is introduced to control the traction battery to be discharged, which may suppress lithium precipitation when the traction battery has the risk of lithium precipitation, so that the safety performance of the traction battery can be improved.

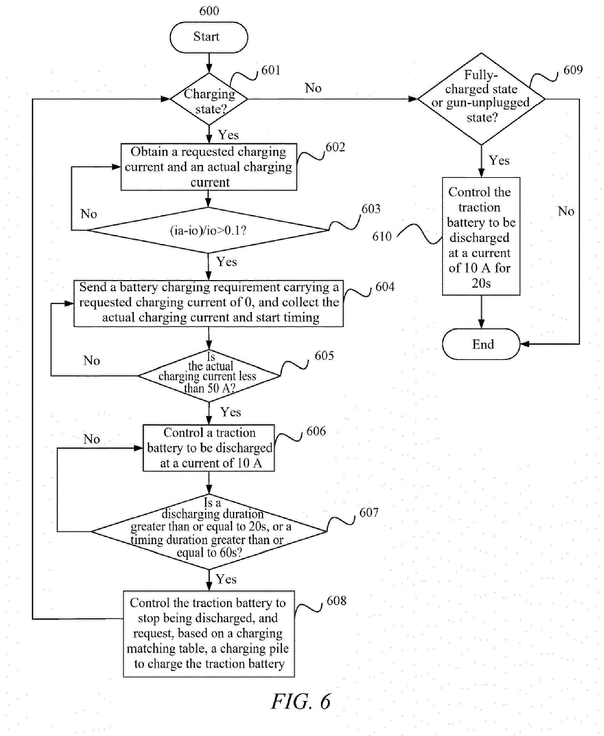

FIG. 6 is a schematic flowchart of a method 600 for charging a traction battery according to an embodiment of the present application. As shown in FIG. 6, the method 600 may be performed by a BMS, and the method 600 may include a part or all of the following content.

In S601, whether a traction battery is in a charging state is determined.

In S602, if it is determined in S601 that the traction battery is in the charging state, the BMS may record a requested charging current io of the traction battery in real time, and collect an actual charging current ia of the traction battery in real time.

Optionally, if it is determined in S601 that the traction battery is not in the charging state, step S609 is performed.

In S603, whether (ia-io)/io is greater than 0.1 is determined.

In S604, if a determining result in S603 is yes, a battery charging requirement carrying a requested charging current of 0 is sent to a charging pile, and the actual charging current of the traction battery is collected in real time and timing is started.

Optionally, if the determining result in S603 is no, step S602 is performed.

In S605, whether the actual charging current of the traction battery is less than 50 A is determined.

In S606, if a determining result in S605 is yes, the traction battery is controlled to be discharged at a current of 10 A.

Optionally, if the determining result in S605 is no, step S604 is performed.

In S607, whether a discharging duration of the traction battery is greater than or equal to 20s is determined, or whether a timing duration in step S604 is greater than or equal to 60s is determined.

In S608, if a determining result in S607 is yes, the traction battery is controlled to stop being discharged, and the charging pile is requested, based on a charging matching table, to charge the traction battery.

Optionally, if the determining result in S607 is no, step S606 is performed.

In S609, if it is determined in S601 that the traction battery is in a non-charging state, whether the traction battery is in a fully-charged state or a gun-unplugged state is determined.

In S610, if it is determined in S609 that the traction battery is in the fully-charged state or the gun-unplugged state, the traction battery is controlled to be discharged at a current of 10 A for 20s.

Optionally, if it is determined in S609 that the traction battery is not in the fully-charged state or the gun-unplugged state, the method 600 ends.

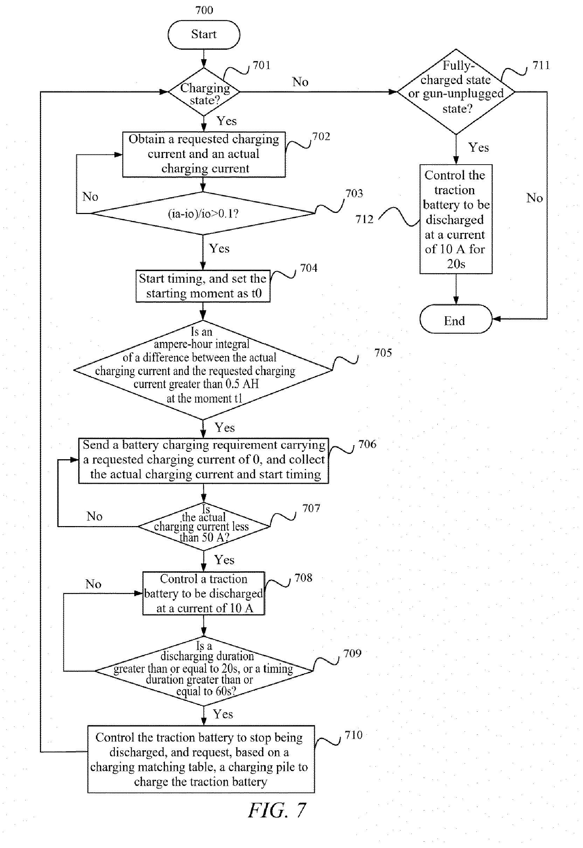

FIG. 7 is a schematic flowchart of a method 700 for charging a traction battery according to an embodiment of the present application. As shown in FIG. 7, the method 700 may be performed by a BMS, and the method 700 may include a part or all of the following content.

In S701, whether a traction battery is in a charging state is determined.

In S702, if it is determined in S701 that the traction battery is in the charging state, the BMS may record a requested charging current of the traction battery in real time, and collect an actual charging current of the traction battery in real time.

Optionally, if it is determined in S701 that the traction battery is not in the charging state, step S711 is performed.

In S703, whether (ia-io)/io is greater than 0.1 is determined.

In S704, if a determining result in S703 is yes, timing is started, and the starting moment is set to t0.

Optionally, if the determining result in S703 is no, step S702 is performed.

In S705, whether an ampere-hour integral of a difference between the actual charging current and the requested charging current is greater than 0.5 AH is determined at the moment t1.

In S706, if a determining result in S705 is yes, the ampere-hour integral calculated in S705 is reset to 0, a battery charging requirement carrying a requested charging current of 0 is sent to a charging pile, and the actual charging current of the traction battery is collected in real time and timing is started.

Optionally, if the determining result in S705 is no, the ampere-hour integral calculated in S705 is recorded and added to an ampere-hour integral obtained next time.

In S707, after S706, whether the actual charging current of the traction battery is less than 50 A is determined.

In S708, if a determining result in S707 is yes, the traction battery is controlled to be discharged at a current of 10A.

Optionally, if the determining result in S707 is no, step S706 is performed.

In S709, whether a discharging duration of the traction battery is greater than or equal to 20s is determined, or whether a timing duration in step S704 is greater than or equal to 60s is determined.

In S710, if a determining result in S709 is yes, the traction battery is controlled to stop being discharged, and the charging pile is requested, based on a charging matching table, to charge the traction battery.

Optionally, if the determining result in S709 is no, step S708 is performed.

In S711, if it is determined in S701 that the traction battery is in a non-charging state, whether the traction battery is in a fully-charged state or a gun-unplugged state is determined.

In S712, if it is determined in S701 that the traction battery is in the fully-charged state or the gun-unplugged state, the traction battery is controlled to be discharged at a current of 10 A for 20s.

Optionally, if it is determined in S711 that the traction battery is not in the fully-charged state or the gun-unplugged state, the method 700 is ended.

It should be understood that, in the embodiments of the present application, sequence numbers of the foregoing processes do not mean execution sequences. The execution sequences of the processes should be determined according to functions and internal logic of the processes, and should not be construed as any limitation on the implementation processes of the embodiments of the present application.

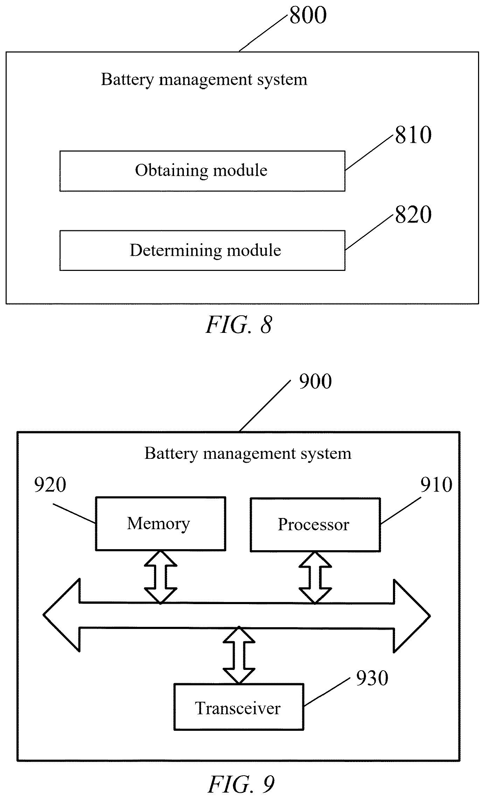

The method for charging a traction battery according to the embodiments of the present application is described above in detail. A battery management system according to an embodiment of the present application is described below in detail with reference to FIG. 8 and FIG. 9. The technical features described in the method embodiments are applicable to the following apparatus embodiments.

FIG. 8 is a schematic block diagram of a battery management system 800 according to an embodiment of the present application. As shown in FIG. 8, the battery management system 800 includes:

an obtaining module 810 configured to obtain an actual charging current of a traction battery during a charging process of the traction battery; and

a determining module 820 configured to determine, based on a degree of the actual charging current exceeding a requested charging current, whether to control the traction battery to be discharged.

Optionally, in the embodiment of the present application, the determining module 820 is specifically configured to: when a ratio of a difference between the actual charging current and the requested charging current to the requested charging current is greater than a first threshold, determine to control the traction battery to be discharged.

Optionally, in the embodiment of the present application, the determining module 820 is specifically configured to: when a ratio of a difference between the actual charging current and the requested charging current to the requested charging current is greater than a first threshold, determine an ampere-hour integral of the difference between the actual charging current and the requested charging current; and when the ampere-hour integral is greater than a second threshold, determine to control the traction battery to be discharged.

Optionally, in the embodiment of the present application, the battery management system 800 further includes: a communication module configured to: when it is determined to control the traction battery to be discharged, send first charging request information to a charging pile, the first charging request information being used to request that a charging current be 0; and a control module configured to: when the collected actual charging current of the traction battery is less than or equal to a third threshold, control the traction battery to be discharged.

Optionally, in the embodiment of the present application, the control module is further configured to: when a duration elapsed after the first charging request information is sent is greater than or equal to a first preset time interval, control the traction battery to stop being discharged.

Optionally, in the embodiment of the present application, the battery management system 800 further includes: a control module configured to: when a duration for controlling the traction battery to be discharged is greater than or equal to a second preset time interval, control the traction battery to stop being discharged.

Optionally, in the embodiment of the present application, the battery management system 800 further includes: a communication module configured to: when the traction battery is controlled to stop being discharged, send second charging request information to the charging pile based on a charging matching table, the second charging request information being used to request the charging pile to charge the traction battery.

It should be understood that the battery management system 800 according to the embodiment of the present application may correspond to the BMS in the method embodiments of the present application, and the above and other operations and/or functions of the units in the battery management system 800 are used to implement the corresponding processes of the battery management system in the methods in FIG. 2 to FIG. 4, FIG. 6, and FIG. 7, and will no longer be described herein for the purpose of brevity.

FIG. 9 is a schematic block diagram of a battery management system 900 according to another embodiment of the present application. As shown in FIG. 9, the battery management system 900 includes a processor 910 and a memory 920, where the memory 920 is configured to store instructions, and the processor 910 is configured to read the instructions and perform the method in the above embodiments of the present application based on the instructions.

The memory 920 may be a separate component independent of the processor 910, or may be integrated into the processor 910.

Optionally, as shown in FIG. 9, the battery management system 900 may further include a transceiver 930, and the processor 910 may control the transceiver 930 to communicate with another device such as a charging pile. Specifically, information or data may be sent to the another device, or information or data sent by the another device may be received.

An embodiment of the present application further provides a readable storage medium configured to store a computer program, where the computer program is used to execute the methods of the above embodiments of the present application.

Those of ordinary skill in the art may realize that units and algorithm steps of various examples described with reference to the embodiments disclosed in this specification can be implemented by using electronic hardware, or a combination of computer software and electronic hardware. Whether these functions are implemented in hardware or software depends on specific applications and design constraints of the technical solutions. A person skilled in the art may use different methods to implement the described functions for each particular application, but it should not be considered that the implementation goes beyond the scope of the present application.

A person skilled in the art can clearly understand that, for the convenience and brevity of the description, references can be made to the corresponding process in the foregoing method embodiment for the specific working process of the system, the apparatus and the unit described above, and details are not described herein again.

In the several embodiments provided in the present application, it should be understood that the disclosed system, apparatus and method can be achieved by other methods. For example, the described apparatus embodiments are merely examples. For example, the unit division is merely logical function division and may be other division in actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separated, and parts displayed as units may or may not be physical units, that is, they may be located in one position, or may be distributed on a plurality of network units. Some or all of the units may be selected according to actual requirements to achieve the objectives of the solutions of the embodiments.

In addition, various functional units in the various embodiments of the present application may be integrated into one processing unit, or various units may be physically present separately, or two or more units may be integrated into one unit.

The functions, if implemented in the form of a software functional unit and sold or used as an independent product, may be stored in a computer-readable storage medium. Based on such understanding, the technical solution of the present application, in essence or the contribution to the prior art, or part of the technical solution may be embodied in the form of a software product. The computer software product is stored in a storage medium, and includes a plurality of instructions used to cause a computer device (which may be a personal computer, a server, or a network device, etc.) to perform all or part of the steps of the method described in various embodiments of the present application. The storage medium includes: a USB flash disk, a mobile hard disk, a read-only memory (ROM), a random access memory (RAM), or a magnetic disk or optical disc or other various media capable of storing program codes.

The above description is only specific embodiments of the present application, but the protection scope of the present application is not limited thereto, and variations and replacements that can be easily conceived within the technical scope disclosed in the present application by any person skilled in the art should fall within the protection scope of the present application. Therefore, the protection scope of the present application shall be subject to the protection scope of the claims.

## Claims

1. A method for charging a traction battery, comprising:

   obtaining an actual charging current of a traction battery during a charging process of the traction battery; and
   determining, based on a degree of the actual charging current exceeding a requested charging current, whether to control the traction battery to be discharged.

2. The method according to claim 1, wherein the determining, based on a degree of the actual charging current exceeding a requested charging current, whether to control the traction battery to be discharged comprises:
   when a ratio of a difference between the actual charging current and the requested charging current to the requested charging current is greater than a first threshold, determining to control the traction battery to be discharged.

3. The method according to claim 1, wherein the determining, based on a degree of the actual charging current exceeding a requested charging current, whether to control the traction battery to be discharged comprises:

   when a ratio of a difference between the actual charging current and the requested charging current to the requested charging current is greater than a first threshold, determining an ampere-hour integral of the difference between the actual charging current and the requested charging current; and

   when the ampere-hour integral is greater than a second threshold, determining to control the traction battery to be discharged.

4. The method according to any one of claims 1 to 3, further comprising:

   when it is determined to control the traction battery to be discharged, sending first charging request information to a charging pile, the first charging request information being used to request that a charging current be 0; and
   when the collected actual charging current of the traction battery is less than or equal to a third threshold, controlling the traction battery to be discharged.

5. The method according to claim 4, further comprising:
   when a duration elapsed after the first charging request information is sent is greater than or equal to a first preset time interval, controlling the traction battery to stop being discharged.

6. The method according to any one of claims 1 to 4, further comprising:
   when a duration for controlling the traction battery to be discharged is greater than or equal to a second preset time interval, controlling the traction battery to stop being discharged.

7. The method according to claim 5 or 6, further comprising:
   when the traction battery is controlled to stop being discharged, sending second charging request information to the charging pile based on a charging matching table, the second charging request information being used to request the charging pile to charge the traction battery.

8. A battery management system, comprising:

   an obtaining module configured to obtain an actual charging current of a traction battery during a charging process of the traction battery; and
   a determining module configured to determine, based on a degree of the actual charging current exceeding a requested charging current, whether to control the traction battery to be discharged.

9. The battery management system according to claim 8, wherein the determining module is specifically configured to:
   when a ratio of a difference between the actual charging current and the requested charging current to the requested charging current is greater than a first threshold, determine to control the traction battery to be discharged.

**10.** The battery management system according to claim 8, wherein the determining module is specifically configured to:

> when a ratio of a difference between the actual charging current and the requested charging current to the requested charging current is greater than a first threshold, determine an ampere-hour integral of the difference between the actual charging current and the requested charging current; and
> when the ampere-hour integral is greater than a second threshold, determine to control the traction battery to be discharged.

**11.** The battery management system according to any one of claims 8 to 10, further comprising:

> a communication module configured to: when it is determined to control the traction battery to be discharged, send first charging request information to a charging pile, the first charging request information being used to request that a charging current be 0; and
> a control module configured to: when the collected actual charging current of the traction battery is less than or equal to a third threshold, control the traction battery to be discharged.

**12.** The battery management system according to claim 11, wherein the control module is further configured to:
when a duration elapsed after the first charging request information is sent is greater than or equal to a first preset time interval, control the traction battery to stop being discharged.

**13.** The battery management system according to any one of claims 8 to 11, further comprising:
a control module configured to: when a duration for controlling the traction battery to be discharged is greater than or equal to a second preset time interval, control the traction battery to stop being discharged.

**14.** The battery management system according to claim 12 or 13, further comprising:
a communication module configured to: when the traction battery is controlled to stop being discharged, send second charging request information to the charging pile based on a charging matching table, the second charging request information being used to request the charging pile to charge the traction battery.

**15.** A battery management system, comprising a memory and a processor, wherein the memory is configured to store instructions, and the processor is configured to read the instructions and perform, based on the instructions, the method according to any one of claims 1 to 7.

101  100  102

Battery system

Charging device — 101

Traction battery — 110

BMS — 120

Power consuming device — 102

*FIG. 1*

200

| Obtain an actual charging current of a traction battery during a charging process of the traction battery | S210 |

| Determine, based on a degree of the actual charging current exceeding a requested charging current, whether to control the traction battery to be discharged | S220 |

*FIG. 2*

300

Obtain an actual charging current of a traction battery during a charging process of the traction battery ~ S310

When a ratio of a difference between the actual charging current and a requested charging current to the requested charging current is greater than a first threshold, determine to control the traction battery to be discharged ~ S320

*FIG. 3*

400

Obtain an actual charging current of a traction battery during a charging process of the traction battery ~ S410

When a ratio of a difference between the actual charging current and a requested charging current to the requested charging current is greater than a first threshold, determine an ampere-hour integral of the difference between the actual charging current and the requested charging current ~ S420

When the ampere-hour integral is greater than a second threshold, determine to control the traction battery to be discharged ~ S420

*FIG. 4*

*FIG. 5*

600

**Start**

601

Charging state?

No

Fully-charged state or gun-unplugged state?

609

Yes

Obtain a requested charging current and an actual charging current

602

No

(ia-io)/io>0.1?

603

610

Yes

Control the traction battery to be discharged at a current of 10 A for 20s

No

Send a battery charging requirement carrying a requested charging current of 0, and collect the actual charging current and start timing

604

End

No

Is the actual charging current less than 50 A?

605

Yes

No

Control a traction battery to be discharged at a current of 10 A

606

No

Is a discharging duration greater than or equal to 20s, or a timing duration greater than or equal to 60s?

607

Yes

Control the traction battery to stop being discharged, and request, based on a charging matching table, a charging pile to charge the traction battery

608

*FIG. 6*

700
Start

701
Charging state? — No → 711 Fully-charged state or gun-unplugged state?

Yes

702 Obtain a requested charging current and an actual charging current

711 Fully-charged state or gun-unplugged state? — Yes → 712 Control the traction battery to be discharged at a current of 10 A for 20s → End

711 ... — No → End

703 (ia-io)/io>0.1? — No (back to 702)

Yes

704 Start timing, and set the starting moment as t0

705 Is an ampere-hour integral of a difference between the actual charging current and the requested charging current greater than 0.5 AH at the moment t1

Yes

706 Send a battery charging requirement carrying a requested charging current of 0, and collect the actual charging current and start timing

707 Is the actual charging current less than 50 A? — No (back to 706)

Yes

708 Control a traction battery to be discharged at a current of 10 A

709 Is a discharging duration greater than or equal to 20s, or a timing duration greater than or equal to 60s? — No (back to 708)

Yes

710 Control the traction battery to stop being discharged, and request, based on a charging matching table, a charging pile to charge the traction battery

FIG. 7

800

Battery management system

| Obtaining module | 810 |

| Determining module | 820 |

*FIG. 8*

900

Battery management system

920

| Memory | | Processor | 910 |

| Transceiver | 930 |

*FIG. 9*

## INTERNATIONAL SEARCH REPORT

| International application No. |
| --- |
| **PCT/CN2021/117312** |

### A. CLASSIFICATION OF SUBJECT MATTER

H02J 7/00(2006.01)i

According to International Patent Classification (IPC) or to both national classification and IPC

### B. FIELDS SEARCHED

Minimum documentation searched (classification system followed by classification symbols)

H02J7/-

Documentation searched other than minimum documentation to the extent that such documents are included in the fields searched

Electronic data base consulted during the international search (name of data base and, where practicable, search terms used)

CNTXT; WPABSC; CNABS; OETXT; WPABS; ENTXT; DWPI; ENTXTC; VEN; CNKI; IEEE: 宁德时代新能源科技股份有限公司, 黄珊, 李世超, 李海力, 赵微, 林真, 锂, 电池, 析, 沉积, 极化, 老化, 劣化, 充电, 电流, 放电, 请求, 检测, 测量, 检测, 测试, 量测, 判断, 超出, 超过, 大于, 大过, 过电流, 比例, 百分比, 程度, 阈值, 阀值, 门限值, 不再充电, 停止充电, 结束充电, 不充电, 负脉冲, 反向脉冲, 反脉冲, charg+, discharg+, battery, lithium, precipitation, pulse, reverse, threshold, current, detect, monitor, overcurrent, fault, failure, diagnose.

### C. DOCUMENTS CONSIDERED TO BE RELEVANT

| Category* | Citation of document, with indication, where appropriate, of the relevant passages | Relevant to claim No. |
| --- | --- | --- |
| X | CN 110696649 A (JIANGSU CHES NEW ENERGY TECHNOLOGY CO., LTD.) 17 January 2020 (2020-01-17) <br> description, paragraphs 32-48 | 1-15 |
| A | CN 104040823 A (H-TECH AG) 10 September 2014 (2014-09-10) <br> entire document | 1-15 |
| A | CN 108695912 A (NINGDE CONTEMPORARY AMPEREX TECHNOLOGY CO., LTD.) 23 October 2018 (2018-10-23) <br> entire document | 1-15 |
| A | CN 105247756 A (H-TECH AG) 13 January 2016 (2016-01-13) <br> entire document | 1-15 |
| A | CN 107104249 A (DONGGUAN AMPEREX TECHNOLOGY LTD. et al.) 29 August 2017 (2017-08-29) <br> entire document | 1-15 |

☑ Further documents are listed in the continuation of Box C.     ☑ See patent family annex.

| | |
| --- | --- |
| * Special categories of cited documents: <br> "A" document defining the general state of the art which is not considered to be of particular relevance <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
| --- | --- |
| **12 May 2022** | **30 May 2022** |

| Name and mailing address of the ISA/CN | Authorized officer |
| --- | --- |
| **China National Intellectual Property Administration (ISA/CN)** <br> **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

## INTERNATIONAL SEARCH REPORT

| | International application No. |
| --- | --- |
| | **PCT/CN2021/117312** |

### C. DOCUMENTS CONSIDERED TO BE RELEVANT

| Category* | Citation of document, with indication, where appropriate, of the relevant passages | Relevant to claim No. |
| --- | --- | --- |
| A | CN 102027653 A (TOYOTA MOTOR CORP.) 20 April 2011 (2011-04-20)<br>entire document | 1-15 |
| A | CN 105449788 A (DONGGUAN NVT TECHNOLOGY CO., LTD.) 30 March 2016 (2016-03-30)<br>entire document | 1-15 |
| A | CN 111896877 A (GUANGDONG OPPO MOBILE COMMUNICATIONS CO., LTD.) 06 November 2020 (2020-11-06)<br>entire document | 1-15 |
| A | CN 110828924 A (SHENZHEN XINHENGYE BATTERY TECHNOLOGY CO., LTD.) 21 February 2020 (2020-02-21)<br>entire document | 1-15 |
| A | US 2018294658 A1 (CONTEMPORARY AMPEREX TECHNOLOGY CO., LTD.) 11 October 2018 (2018-10-11)<br>entire document | 1-15 |

Form PCT/ISA/210 (second sheet) (January 2015)

<table>
<tr><td colspan="2"><strong>INTERNATIONAL SEARCH REPORT</strong><br>Information on patent family members</td><td colspan="2">International application No.<br><strong>PCT/CN2021/117312</strong></td></tr>
</table>

| Patent document cited in search report | | | Publication date (day/month/year) | Patent family member(s) | | | Publication date (day/month/year) |
|---|---|---|---|---|---|---|---|
| CN | 110696649 | A | 17 January 2020 | None | | | |
| CN | 104040823 | A | 10 September 2014 | JP | 2015504648 | A | 12 February 2015 |
| | | | | EP | 2786467 | A2 | 08 October 2014 |
| | | | | US | 2014327406 | A1 | 06 November 2014 |
| | | | | WO | 2013079611 | A2 | 06 June 2013 |
| | | | | DE | 102011087496 | A1 | 27 June 2013 |
| | | | | KR | 20140097458 | A | 06 August 2014 |
| | | | | WO | 2013079611 | A3 | 01 August 2013 |
| | | | | KR | 101588324 | B1 | 25 January 2016 |
| | | | | JP | 5952913 | B2 | 13 July 2016 |
| | | | | CN | 104040823 | B | 01 August 2017 |
| | | | | US | 9793733 | B2 | 17 October 2017 |
| | | | | EP | 2786467 | B1 | 01 August 2018 |
| CN | 108695912 | A | 23 October 2018 | US | 2018294658 | A1 | 11 October 2018 |
| | | | | CN | 108695912 | B | 02 October 2020 |
| | | | | US | 11075525 | B2 | 27 July 2021 |
| CN | 105247756 | A | 13 January 2016 | EP | 2997637 | A1 | 23 March 2016 |
| | | | | JP | 2016518807 | A | 23 June 2016 |
| | | | | TW | 201517448 | A | 01 May 2015 |
| | | | | DE | 102013105119 | A1 | 04 December 2014 |
| | | | | KR | 20160009049 | A | 25 January 2016 |
| | | | | WO | 2014184338 | A1 | 20 November 2014 |
| | | | | US | 2016149430 | A1 | 26 May 2016 |
| | | | | DE | 102013105119 | B4 | 03 March 2016 |
| | | | | TW | I525959 | B | 11 March 2016 |
| | | | | JP | 6151852 | B2 | 21 June 2017 |
| | | | | CN | 105247756 | B | 11 September 2018 |
| | | | | KR | 101886639 | B1 | 11 September 2018 |
| | | | | EP | 2997637 | B1 | 26 December 2018 |
| CN | 107104249 | A | 29 August 2017 | US | 2017244255 | A1 | 24 August 2017 |
| | | | | EP | 3211709 | A1 | 30 August 2017 |
| | | | | KR | 20170099378 | A | 31 August 2017 |
| | | | | JP | 2017152356 | A | 31 August 2017 |
| | | | | WO | 2017143761 | A1 | 31 August 2017 |
| | | | | JP | 6254232 | B2 | 27 December 2017 |
| | | | | KR | 101873329 | B1 | 03 July 2018 |
| | | | | US | 10164456 | B2 | 25 December 2018 |
| | | | | CN | 107104249 | B | 30 August 2019 |
| | | | | EP | 3211709 | B1 | 11 September 2019 |
| CN | 102027653 | A | 20 April 2011 | WO | 2009139252 | A1 | 19 November 2009 |
| | | | | AU | 2009247429 | A1 | 19 November 2009 |
| | | | | EP | 2282389 | A1 | 09 February 2011 |
| | | | | BR | PI0912600 | A2 | 26 January 2016 |
| | | | | JP | 4356792 | B1 | 04 November 2009 |
| | | | | US | 2011057618 | A1 | 10 March 2011 |
| | | | | RU | 2010150734 | A | 20 June 2012 |
| | | | | CN | 102027653 | B | 22 April 2015 |
| | | | | JP | 2009278745 | A | 26 November 2009 |
| | | | | AU | 2009247429 | B2 | 23 August 2012 |

Form PCT/ISA/210 (patent family annex) (January 2015)

**INTERNATIONAL SEARCH REPORT**
Information on patent family members

| International application No. |
|---|
| **PCT/CN2021/117312** |

| Patent document cited in search report | | | Publication date (day/month/year) | Patent family member(s) | | | Publication date (day/month/year) |
|---|---|---|---|---|---|---|---|
| | | | | RU | 2475919 | C2 | 20 February 2013 |
| | | | | US | 9136723 | B2 | 15 September 2015 |
| | | | | BRP | I0912600 | A2 | 26 January 2016 |
| | | | | EP | 2282389 | A4 | 11 January 2017 |
| | | | | BRP | I0912600 | B1 | 17 March 2020 |
| CN | 105449788 | A | 30 March 2016 | None | | | |
| CN | 111896877 | A | 06 November 2020 | None | | | |
| CN | 110828924 | A | 21 February 2020 | CN | 110828924 | B | 25 May 2021 |
| US | 2018294658 | A1 | 11 October 2018 | CN | 108695912 | A | 23 October 2018 |
| | | | | US | 11075525 | B2 | 27 July 2021 |
| | | | | CN | 108695912 | B | 02 October 2020 |

Form PCT/ISA/210 (patent family annex) (January 2015)